Europäisches Patentamt

European Patent Office

Office européen des brevets

(11) Numéro de publication: **0 252 429**
**A1**

# (12) DEMANDE DE BREVET EUROPEEN

(21) Numéro de dépôt: 87109485.0

(22) Date de dépôt: 01.07.87

(51) Int. Cl.⁴: **H01L 23/36**

(30) Priorité: 09.07.86 FR 8610141

(43) Date de publication de la demande:
**13.01.88 Bulletin 88/02**

(84) Etats contractants désignés:
**CH DE FR GB LI NL**

(71) Demandeur: **EM Microelectronic-Marin SA**

**CH-2074 Marin(CH)**

(72) Inventeur: **Simon, Jean-Luc**
**Cité des Sors 16**
**CH-2074 Marin(CH)**
Inventeur: **Juan, Alain**
**Chemin des Esserts 30**
**CH-2054 Chézard(CH)**

(74) Mandataire: **Barbeaux, Bernard et al**
**ICB Ingénieurs Conseils en Brevets SA**
**Passage Max. Meuron 6**
**CH-2001 Neuchâtel(CH)**

(54) **Dispositif électronique à semi-conducteur comportant des moyens de refroidissement.**

(57) L'invention concerne les dispositifs électroniques à semi-conducteur qui ont besoin d'être munis de moyens de refroidissement comme par exemple les transistors de puissance ou les circuits intégrés qui en comprennent.

Dans un dispositif électronique selon l'invention qui comporte une plaquette de matériau semi-conducteur (1) dont une face présente au moins une zone active (7) et porte des métallisations (4, 5, 6) et des plots de contact (10) pour former un composant électronique intégré (3) et une couche de matière isolante de protection (8) qui recouvre cette face de la plaquette, ces moyens de refroidissement comprennent une plage métallique (14) formée sur cette couche de protection, qui recouvre au moins une partie de la zone active de ce composant, un élément dissipateur de chaleur (16) et une liaison métallique (15) entre cet élément et la plage.

Fig. 1

## DISPOSITIF ELECTRONIQUE A SEMI-CONDUCTEUR COMPORTANT DES MOYENS DE REFROIDISSEMENT

La présente invention concerne les dispositifs électroniques à semi-conducteur et plus précisément ceux qui ont besoin d'être munis de moyens de refroidissement comme par exemple les transistors de puissance ou les circuits qui comprennent de tels transistors.

On connaît actuellement différentes solutions pour dissiper la chaleur dégagée par un composant ou un circuit électronique réalisé sur une plaquette de matériau semi-conducteur.

La plus courante consiste à faire appel à un radiateur et à le placer à l'extérieur de l'enveloppe de protection de la puce, c'est-à-dire de la plaquette.

Lorsque cette enveloppe est un boîtier métallique ce radiateur est généralement mis simplement en contact avec elle, directement ou par l'intermédiaire d'une feuille de matière électriquement isolante. Par contre, lorsqu'il s'agit d'un boîtier en plastique ou d'un simple enrobage de résine époxyde ou d'une autre matière du même genre on montre le plus souvent celui-ci sur une pièce métallique qui le relie à la face arrière de la puce et qui peut parfois jouer aussi un rôle électrique.

Il arrive également que le radiateur soit placé directement en contact avec cette face arrière, par exemple lorsque la puce n'est que partiellement enrobée, mais cela est rare.

Dans tous les cas l'efficacité de cette solution est limitée par le fait que, pour atteindre le radiateur, la chaleur dégagée par le composant ou le circuit doit traverser toute l'épaisseur de matériau semi-conducteur qui se trouve au-dessous de lui, c'est-à-dire pratiquement celle de la plaquette et que ce matériau ne présente pas une très bonne conductibilité thermique.

Une autre solution connue, qui est décrite sommairement à la page 4494 de l'"IBM Technical Disclosure Bulletin", Vol. 21, No 11, d'avril 1979, consiste à former en même temps que les plots de contact de la puce et sur la couche de matière isolante de protection qui recouvre la face avant de celle-ci de petites plages métalliques isolées qui sont réparties au-dessus du composant ou du circuit.

Dans ce cas, pour atteindre les plages, la chaleur doit seulement franchir la couche de protection qui n'est pas elle non plus constituée par un matériau de très bonne conductibilité thermique mais qui a toujours une épaisseur très inférieure à celle de la plaquette.

Malheureusement, comme une puce de circuit intégré est déjà très petite, la surface de ces plages est forcément très faible ce qui fait qu'elles ne peuvent pas permettre de refroidir un composant ou un circuit qui dégage une quantité de chaleur importante.

Le but de l'invention est précisément de remédier à cela et il est atteint grâce au fait que dans un dispositif électronique selon l'invention qui comporte lui aussi, évidemment, une plaquette de matériau semi-conducteur dont une face présente au moins une zone active et porte des métallisations et des plots de contact pour former un composant électronique intégré, une couche de matière isolante de protection qui recouvre cette face de la plaquette sauf aux endroits des plots et des moyens de refroidissement, ces derniers ne comprennent pas seulement au moins une plage métallique formée sur la couche de protection et qui couvre une partie au moins de la zone active mais également un élément dissipateur de chaleur et une liaison métallique entre cet élément et la plage métallique.

Selon la quantité de chaleur que le composant peut produire et la façon dont la puce est conditionnée l'élément dissipateur en question peut être par exemple simplement une bande conductrice d'un circuit imprimé sur lequel la puce protégée est montée ou un radiateur classique ou encore le boîtier métallique dans lequel la puce est enfermée.

L'invention sera mieux comprise à la lecture de la description qui suit d'une forme particulière de mise en oeuvre, choisie à titre d'exemple, et à la vue du dessin annexé à cette description, sur lequel:

-la figure 1 est une vue en perspective - schématique et partielle de cette forme d'exécution, et

-les figures 2A et 2B des vues en coupe également partielles et agrandies, suivant les lignes A-A et B-B de la précédente.

Tel qu'il est représenté sur le dessin le dispositif électronique selon l'invention comprend une puce 1 avec un substrat en silicium 2 sur lequel a été formé seulement un transistor de puissance de type MOS 3. Cette situation n'est pas rare vu la surface que peut occuper un tel transistor.

Pour simplifier les figures ne montrent de ce transistor 3 que les métallisations de drain 4, de source 5 et de grille 6 avec leurs plages respectives de connexion $4_a$, $5_a$ et $6_a$. Les autres parties, c'est-à-dire au moins la diffusion de source, la diffusion de drain, le canal et la couche mince d'oxyde de silicium ($SiO_2$) située sous la

métallisation de grille sont seulement figurées sur la vue en coupe du dispositif par une zone 7, délimitée par une ligne en traitillés, dans laquelle elles se trouvent et qui constitue dans ce cas la zone active dont on a parlé.

Pour la même raison la couche d'oxyde de silicium de protection que l'on a l'habitude de former à la surface du silicium en premier lieu, c'est-à-dire avant même de réaliser le transistor, n'a pas elle non plus été représentée.

Par contre, on peut voir sur ces figures la deuxième couche isolante de protection 8 souvent en verre mais qui peut être aussi par exemple en nitrure de silicium ($Si_3N_4$) ou en polyimide et qui présente au droit des plages de connexion $4_a$, $5_a$ et $6_a$ des métallisations des fenêtres 9 par lesquelles sortent des plots de contact 10, par exemple en or, qui sont reliés par l'intermédiaire de pattes de connexion 11 à des bandes conductrices 12 portées par un support non représenté. Ce support peut être par exemple le substrat d'un circuit imprimé dont les bandes 12 constituent des pistes ou le fond d'un boîtier.

On constate également qu'au-dessus de la zone active 7 du transistor la couche de protection 8 porte une plage 14 formée du même métal et de même épaisseur que les plots 10 mais de surface beaucoup plus grande qu'eux et que cette plage est elle aussi reliée par une patte de connexion 15 à une bande métallique 16 portée par le même support que les autres. Comme on le verra par la suite cette bande peut constituer elle-même l'élément dissipateur de chaleur dont on a parlé ou simplement prolonger la patte 15 pour transmettre la chaleur captée par la plage 14 à celui-ci.

Le fait de choisir le même métal pour la plage 14 que pour les plots 10, comme dans l'article précité de la revue "IBM Technical Disclosure Bulletin", n'est évidemment pas une obligation mais il a le gros avantage de permettre là aussi de réaliser les deux en même temps et ceci très facilement.

En effet, pour former les plots de contact d'un composant ou d'un circuit intégré et en particulier d'un transistor comme celui dont il est question ici on procède généralement de la manière suivante:

Lorsque le transistor se trouve encore avec beaucoup d'autres sur la plaque de silicium dont on est parti et après qu'une couche isolante de protection comme la couche 8 dont on a parlé ait été déposé sur toute la face avant de celle-ci et que des fenêtres y aient été percées aux endroits où les plots de contact doivent se situer on crée sur cette face, par évaporation sous vide, une couche métallique qui n'est pas forcément homogène. Par exemple, lorsque les métallisations du transistor sont en aluminium et qu'on a l'intention d'utiliser effectivement de l'or pour les plots, ce qui arrive très fréquemment, cette couche peut être constituée par deux couches plus minces, l'une de titane-tungstène et l'autre d'or.

Après que cette couche métallique ait été déposée on recouvre la face avant de la plaque et souvent aussi sa face arrière de résine photosensible, on éclaire la face avant à travers un masque, on effectue l'opération de développement qui permet d'ouvrir dans la résine des fenêtres centrées sur celles de la couche de protection et, après un nettoyage soigneux de la plaque pour faire disparaître toute trace de résine sur la couche métallique aux endroits où elle a été mise à nu, on place cette plaque dans une cuve électrolytique contenant un ou plusieurs sels du métal dont les plots doivent être constitués.

Lorsque la plaque est restée suffisamment longtemps dans la cuve pour que les plots aient atteint l'épaisseur voulue on la sort, on la sèche, on enlève la résine qui reste sur sa face avant et, éventuellement, celle que l'on avait mise aussi sur sa face arrière pour éviter un dépôt de métal sur celle-ci et on fait disparaître la couche métallique ailleurs qu'aux emplacements des plots.

Par conséquent, pour obtenir en plus de ces plots une plage comme la plage 14, il suffit de prévoir un masque qui permet de percer dans la résine une fenêtre supplémentaire à l'endroit voulu.

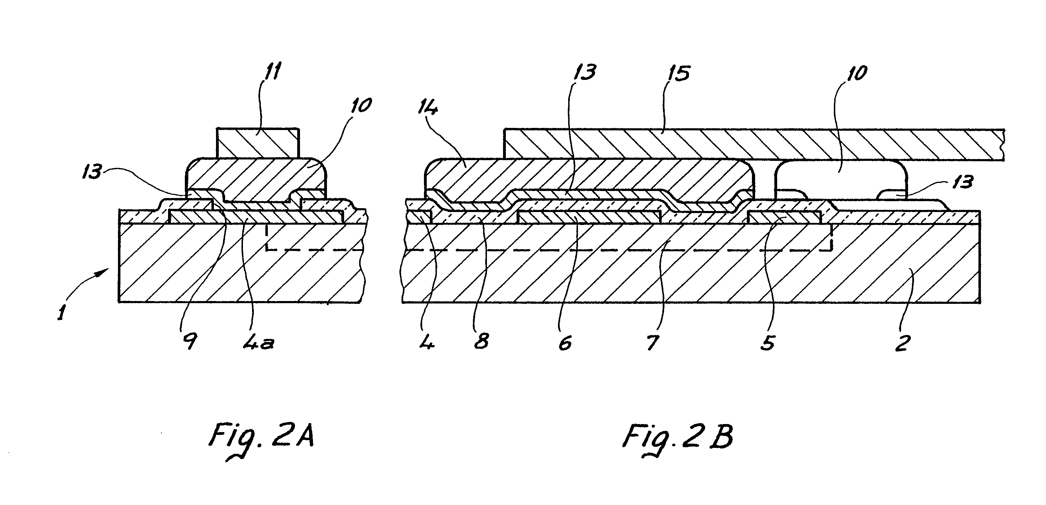

Cela explique que la plage 14 ait la même épaisseur que les plots 10 et que l'on trouve sur les figures 2A et 2B la même couche métallique intermédiaire 13 entre cette plage et la couche isolante 8 et entre ces plots et les plages de connexion $4_a$, $5_a$ et $6_a$ des métallisations du transistor 3.

D'autre part, ce que l'on vient de dire à propos de la plage 14 et des plots 10 est également valable d'une certaine manière pour la patte de connexion 15 et les autres 11.

En effet, si l'on utilise la technique connue sous l'abréviation T.A.B. de l'expression anglaise "Tape Automated Bonding", on peut très bien former en même temps, sur le ruban souple de matière isolante dont on se sert dans cette technique, des groupes non pas de trois mais de quatre bandes conductrices, de formes et de dimensions adéquates, et souder ensuite les bandes de chaque groupe simultanément sur les plots de contact et la plage métallique d'un transistor puis sur d'autres bandes conductrices comme les bandes 12 et 16. Pour cela il suffit que la patte de connexion supplémentaire, associée à la plage, puisse être constituée de la même manière que les autres. Or rien ne s'y oppose car, comme pour les plots, les métaux qui sont employés pour réaliser les pattes de connexion d'un composant ou d'un circuit intégré en général font partie de ceux qui présentent une très bonne conductibilité thermique. Très souvent ces pattes sont, en grande partie tout au moins, en cuivre.

On va voir maintenant, grâce à quelques exemples, comment l'ensemble que l'on vient de décrire peut se suffire à lui-même ou être complété pour former un dispositif conforme à l'invention, en fonction de la puissance du transistor 3, de ce que sont les bandes conductrices 12 et 16 et des moyens de protection non représentés qui peuvent le compléter.

Supposons tout d'abord que la puissance du transistor ne soit pas très élevée, que les bandes conductrices 12 et 16 soient effectivement les pistes d'un circuit imprimé et qu'avant de souder les pattes de connexion 11 et 15 sur celles-ci on ait enrobé la puce 1 de résine. Dans ce cas, si cela peut suffire et si l'on dispose d'assez de place sur la circuit imprimé, il est facile de donner à la bande 16 la surface nécessaire, par exemple en la faisant serpenter, en l'élargissant ou en la ramifiant, pour qu'elle forme elle-même un élément capable de dissiper convenablement la chaleur qui lui est apportée par la plage 14 et la patte 15 et qui représente la plus grande partie de celle dégagée par le transistor vu que ces éléments sont faits de métaux qui présentent une conductibilité thermique nettement supérieure à celle du silicium et de la résine. Sinon, on peut souder un radiateur classique sur la bande, près de la patte 15, cette bande devenant alors une partie de la liaison métallique entre la plage et l'élément dissipateur de chaleur.

Par ailleurs, si une patte devait être ajoutée à l'ensemble représenté sur le dessin, pour relier le substrat 2 du transistor à la masse du circuit dont il est sensé faire partie, il est probable que rien n'empêcherait de la souder elle aussi sur la bande 16 qui serait connectée à cette masse. Une autre possibilité consisterait à fixer cette patte sur une autre piste qui pourrait former un second élément dissipateur de chaleur ou être en contact avec le même radiateur que la bande 16.

Admettons maintenant qu'il n'y ait pas de matière d'enrobage autour de la puce et que les bandes 12 ne soient pas des pistes conductrices d'un circuit imprimé mais des pattes qui sortent d'un boîtier.

Si ce boîtier est en matière plastique la bande 16 est alors elle aussi une patte, mise en contact avec un élément dissipateur de chaleur extérieur qui peut être un radiateur.

Si, au contraire, le boîtier est métallique la bande 15 peut être mise en contact, directement ou par une soudure, avec la base ou le capot de ce boîtier qui, dans ce cas, constitue aussi l'élément dissipateur de chaleur.

Si la quantité de chaleur dégagée par le transistor est trop importante pour que cela suffise il y a alors au moins deux possibilités.

La première c'est de prévoir simplement en plus un radiateur et de la mettre de façon classique en contact avec le boîtier.

La deuxième c'est que la bande 16 soit elle aussi une patte qui sort du boîtier et qui mène à un radiateur extérieur. De plus ce radiateur peut être mis avantageusement, là aussi, en contact direct ou indirect avec le boîtier afin de recevoir en plus la chaleur qui peut lui être transmise par l'intermédiaire du substrat 2 et de ce boîtier.

Evidemment, l'invention n'est pas limitée à ce mode d'exécution que l'on a décrit ni aux différentes possibilités que l'on vient d'envisager pour l'adapter aux moyens de conditionnement dont il peut être muni.

Par exemple, on peut très bien prévoir deux pattes de connexion comme la patte 15 ou plus, soudées d'un côté sur une plage métallique ou sur plusieurs et, de l'autre, sur des bandes conductrices respectives, si l'on estime que le refroidissement du transistor peut grâce à cela être plus efficace.

Par ailleurs, plutôt que d'être isolée la plage métallique pourrait être une extension de l'un des plots de contact 10. Dans ce cas la bande conductrice 12 associée à ce plot pourrait être éventuellement aussi l'élément dissipateur de chaleur relié à la plage par la patte 11 correspondante, ce qui permettrait de supprimer la patte 15 et la bande 16.

De plus, dans le cas d'une puce enfermée dans un boîtier on pourrait parfois, à la limite, se contenter de souder sur la plage un élément métallique qui formerait un petit radiateur interne à ce boîtier.

Enfin, compte tenu de ce qui a été dit jusqu'à présent on voit très bien comment l'invention peut être étendue à des circuits de type MOS ou autre qui comprennent plusieurs composants capables de dégager une quantité de chaleur relativement importante.

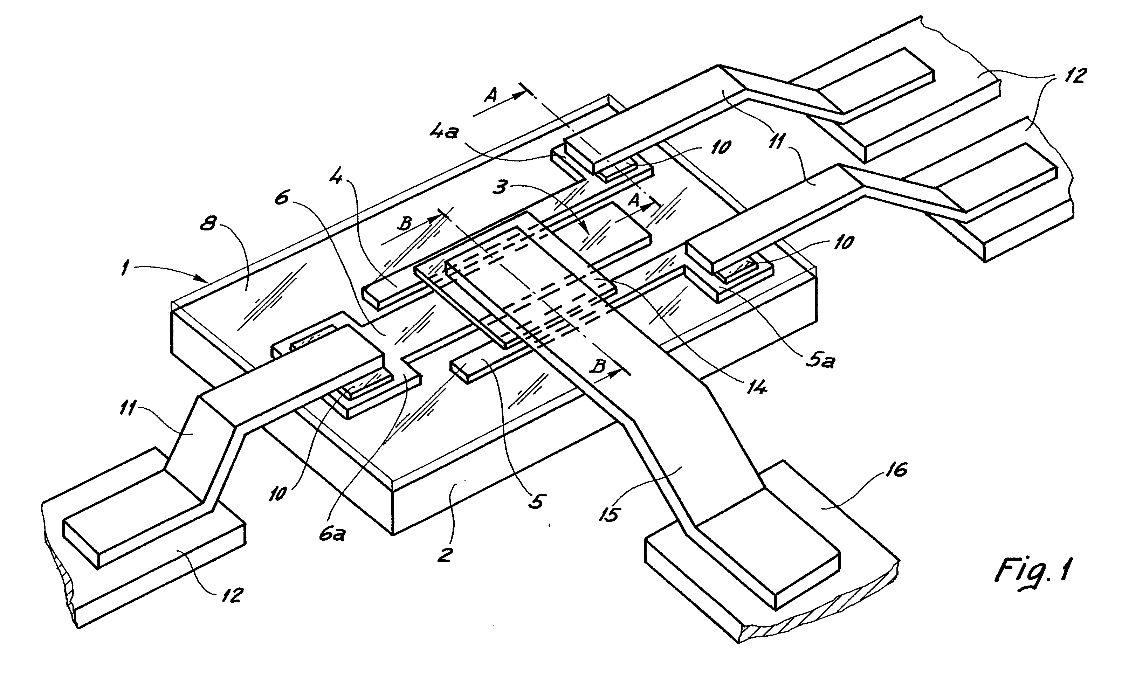

Par exemple, si l'on regarde à nouveau la figure 1 et si l'on imagine qu'il y a sur le substrat de silicium un autre transistor à côté de celui qui a été représenté, on se rend compte immédiatement que, pour refroidir ce transistor supplémentaire, on peut simplement augmenter la surface de la plage métallique pour qu'elle recouvre également la plus grande partie de sa zone active ou prévoir une autre plage au-dessus de cette dernière et lui associer une autre patte de connexion. Ensuite, on a le choix entre relier les deux pattes à une bande

**0 252 429**

conductrice commune ou à des bandes séparées. D'autre part, il est évident que l'on pourrait aussi n'avoir qu'une seule plage et deux pattes de connexion ou plus si cela était utile.

**Revendications**

1. Dispositif électronique comportant une plaquette de matériau semi-conducteur (1) dont une face présente au moins une zone active (7) et porte des métallisations (4, 5, 6) et des plots de contact (10) pour former un composant électronique intégré (3), une couche (8) de matière isolante de protection qui recouvre ladite face de la plaquette sauf aux endroits desdits plots, et des moyens de refroidissement comprenant une plage métallique (14) formée sur ladite couche de protection, qui couvre au moins une partie de ladite zone active, caractérisé par le fait que lesdits moyens de refroidissement comprennent également un élément dissipateur de chaleur (16) et une liaison métallique (15) entre cet élément et ladite plage.

2. Dispositif électronique selon la revendication 1, caractérisé par le fait que ladite plage (14) est en contact avec ladite couche de protection (8) par l'intermédiaire d'une couche métallique (13).

3. Dispositif électronique selon la revendication 1 ou 2, caractérisé par le fait que ladite plage (14) et lesdits plots de contact (10) sont constitués par un même métal.

4. Dispositif électronique selon la revendication 3, caractérisé par le fait que ladite plage (14) et lesdits plots de contact (10) sont en or.

5. Dispositif électronique selon l'une quelconque des revendications précédentes, caractérisé par le fait qu'il comporte également des pattes de connexion (11) pour relier électriquement lesdits plots de contact (10) à des bandes conductrices (12) portées par un support et que ladite liaison métallique comprend elle-même une patte de connexion (15), de même constitution que les autres et qui est fixée, d'un part, sur ladite plage (14) et, d'autre part, sur une bande conductrice supplémentaire (16) que porte ledit support.

6. Dispositif électronique selon la revendication 5, caractérisé par le fait que ladite bande conductrice supplémentaire (16) forme ledit élément dissipateur de chaleur.

Fig.1

Fig. 2A

Fig. 2B

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,A | IBM TECHNICAL DISCLOSURE BULLETIN, vol. 21, no. 11, avril 1979, page 4494, New York, US; E. BERNDLMAIER: "Dummy pads for reduced thermal resistance" | 1-3 | H 01 L   23/36 |
| | --- | | |
| A | GB-A-1 200 426 (HUGHES AIRCRAFT) * Page 4, lignes 22-40 * | 1 | |
| | --- | | |
| A | IEEE TRANSACTIONS MICROWAVE THEORY AND TECHNIQUES, vol. MTT-27, no. 5, mai 1979, pages 463-471, IEEE, New York, US; C.H. OXLEY et al.: "Design and performance of I-Band (8-10-GHz) TRAPATT diodes and amplifiers" * Figure 2 * | 1,4 | |
| | | | DOMAINES TECHNIQUES RECHERCHES (Int. Cl.4) |
| | --- | | |
| A | GB-A-1 426 539 (TOSHIBA) * Figure 2C * | 5 | H 01 L |
| | --- | | |
| A | FR-A-2 112 466 (HONEYWELL) | | |
| | ----- | | |

Le présent rapport de recherche a été établi pour toutes les revendications

| Lieu de la recherche | Date d'achèvement de la recherche | Examinateur |
|---|---|---|
| LA HAYE | 10-09-1987 | DE RAEVE R.A.L. |